# EUROPÄISCHE PATENTANMELDUNG

(11) **EP 1 330 148 A2**
(43) Veröffentlichungstag der Anmeldung: **23.07.2003**
(21) Anmeldenummer: 03000756.1
(22) Anmeldetag: 13.01.2003
(51) Int. Cl.: H05K 5/00

(54) **Elektrisches Gerät**

(30) Priorität: 21.01.2002 DE 10202095
(71) Anmelder: SIEMENS AKTIENGESELLSCHAFT, 80333 München (DE)
(72) Erfinder: Dörrhöfer, Stefan, 61250 Usingen (DE); Nitzsche, Michael, 65795 Hatterheim (DE); Schultz, Dietmar, 61348 Bad Homburg (DE)

(57) **Zusammenfassung**

Bei einem elektrischen Gerät mit einer auf einer Trägerplatte angeordneten Schaltung und mit einem elektrische Leitungen bildenden Stanzgitter zur elektrischen Verbindung der Schaltung mit weiteren elektrischen Bauteilen ist vorgesehen, dass die Trägerplatte in wärmeleitender Verbindung mit mindestens einem Teil des Stanzgitters steht. Dabei kann das Stanzgitter mindestens teilweise flächig ausgebildet sein und die Trägerplatte auf dem flächigen Teil aufliegen. Eine elektrische Isolierung zwischen der Trägerplatte und dem Stanzgitter kann von einer doppelseitig klebenden Folie oder von einem aufgedruckten Kleber gebildet sein.

## Beschreibung

Die Erfindung betrifft ein elektrisches Gerät mit einer auf einer Trägerplatte angeordneten Schaltung und mit einem elektrische Leitungen bildenden Stanzgitter zur elektrischen Verbindung der Schaltung mit weiteren elektrischen Bauteilen.

In elektrischen Geräten, beispielsweise Steuergeräten für Kraftfahrzeuge, werden häufig zur Leitung höherer Ströme sogenannte Stanzgitter verwendet, welche die entsprechenden Bauelemente, wie Spulen und Hochleistungshalbleiterelemente, miteinander verbinden. Komplexere Schaltungen geringerer Leistung werden dabei als Hybridschaltungen oder in gedruckter Schaltungstechnik jeweils auf einer Trägerplatte ausgeführt. Trotz geringerer Verlustleistung benötigen diese Schaltungen Maßnahmen zur Ableitung der Verlustwärme, was mit zusätzlichem, oft mit erheblichem Aufwand verbunden ist. Diese Wärmeableitung wird häufig noch dadurch erschwert, dass die Geräte in geschlossenen Gehäusen angeordnet sind.

Aufgabe der vorliegenden Erfindung ist es, die Ableitung der Verlustwärme in derartigen Schaltungen mit geringen Kosten zu ermöglichen und/oder zu verbessern.

Diese Aufgabe wird erfindungsgemäß dadurch gelöst, dass die Trägerplatte in wärmeleitender Verbindung mit mindestens einem Teil des Stanzgitters steht. Dabei ist vorzugsweise vorgesehen, dass das Stanzgitter mindestens teilweise flächig ausgebildet ist und dass die Trägerplatte auf dem flächigen Teil aufliegt.

Durch die erfindungsgemäßen Maßnahmen ist eine wesentliche Verbesserung der Wärmeableitung von elektrischen Schaltungen, wie Leiterplatten und Hybridschaltungen, in geschlossenen Gehäusen möglich. Dabei wird in vorteilhafter Weise ein in diesen Gehäusen ohnehin vorhandenes Bauteil als Wärmesenke und als Befestigung genutzt. Es entfallen damit weitere Bauteile zur Wärmeableitung und zur Befestigung der Schaltung.

Insbesondere kann zur Befestigung und zur elektrischen Isolierung der Schaltung vorgesehen sein, dass eine elektrische Isolierung zwischen der Trägerplatte und dem Stanzgitter von einer doppelseitig klebenden Folie oder von einem aufgedruckten oder dosierten Kleber gebildet wird.

Eine vorteilhafte Ausgestaltung des erfindungsgemäßen Gerätes besteht darin, dass das Stanzgitter mit Kunststoff umspritzt ist, wobei elektrische Kontaktflächen und zur wärmeleitenden Verbindung mit der Trägerplatte vorgesehene Flächen freigelassen sind. Damit wird durch an sich bekannte Maßnahmen eine Stabilität und Tragfähigkeit des Stanzgitters erzielt.

Eine einfache und sichere Kontaktierung der Schaltung mit dem Stanzgitter ist bei einer anderen vorteilhaften Ausgestaltung des erfindungsgemäßen Gerätes dadurch möglich, dass das Stanzgitter eine größere Fläche einnimmt als die Trägerplatte und dass als Kontaktflächen für die auf der Trägerplatte angeordnete Schaltung vorgesehene Leitungen des Stanzgitters neben der Trägerplatte über die Ebene des Stanzgitters hinausragen.

Eine vorteilhafte Weiterbildung des erfindungsgemäßen Gerätes besteht darin, dass die weiteren elektrischen Bauteile in einem Gehäuse angeordnet sind, wobei elektrische Kontaktelemente in Richtung auf eine offene Seite des Gehäuses weisen und mit Kontaktflächen des Stanzgitters verbunden sind, dass das Kunststoff-umspritzte Stanzgitter die offene Seite des Gehäuses im Wesentlichen einnimmt, wobei die auf der Trägerplatte angeordnete Schaltung nach außen weist, und dass das Gehäuse mit einem Deckel verschließbar ist, der zur Aufnahme mindestens der Schaltung ausgebildet ist. Bei dieser Weiterbildung ist eine einfache Montage des Gerätes und eine sichere Lagerung und Fixierung des Kunststoff-umspritzten Stanzgitters möglich.

Vorzugsweise ist bei dieser Weiterbildung vorgesehen, dass die zur Wärmeleitung vorgesehene Fläche des Stanzgitters den Rand des Gehäuses überragt. Diese Maßnahme vereinfacht das Aufbringen der Isolier- und Klebeschicht bei einer Serienfertigung. So kann beispielsweise ein Siebdruckwerkzeug an die zu bedruckende Fläche des Stanzgitters leicht herangeführt werden, ohne daß der Rand des Gehäuses stört bzw. unbeabsichtigt bedruckt wird.

Die Erfindung läßt zahlreiche Ausführungsformen zu. Eine davon ist schematisch in der Zeichnung anhand mehrerer Figuren dargestellt und nachfolgend beschrieben. Es zeigt:

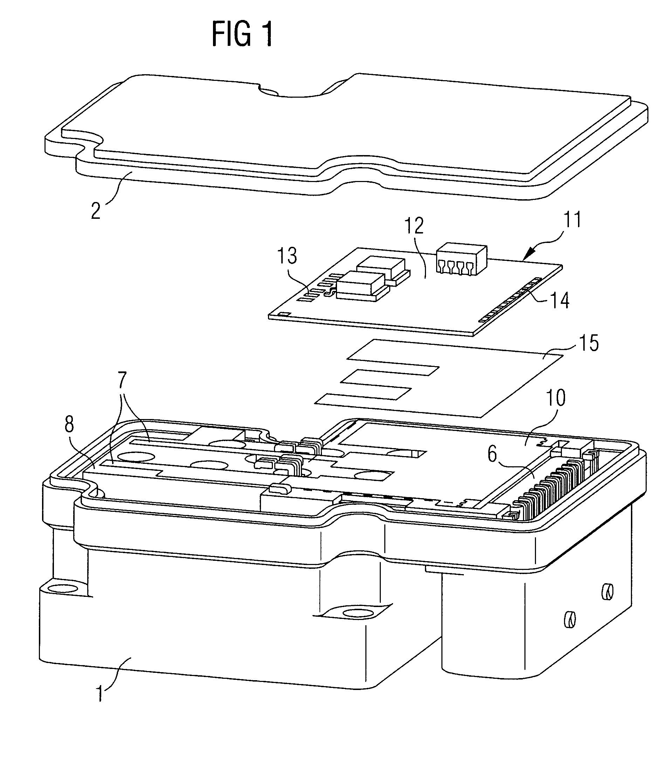

Fig. 1 ein teilweise demontiertes Ausführungsbeispiel,
Fig. 2 das Ausführungsbeispiel mit zusätzlich herausgenommenem Stanzgitter,
Fig. 3 eine Seitenansicht des Ausführungsbeispiels,
Fig. 4 das Stanzgitter,
Fig. 5 das umspritzte Stanzgitter und
Fig. 6 das Stanzgitter mit einer aufgebrachten Schaltung.

Die Figuren zeigen ein praktisch ausgeführtes erfindungsgemäßes Gerät, wobei eine Reihe von Einzelheiten dargestellt sind, die im Zusammenhang mit der Erfindung nicht von Bedeutung und daher auch nicht näher beschrieben sind. Gleiche Teile sind in den Figuren mit gleichen Bezugszeichen versehen.

Das dargestellte Gerät besteht aus einem Gehäuse 1 und einem Deckel 2. In dem Gehäuse sind verschiedene elektrische Bauteile 3 angeordnet, deren Anschlussstifte 4 in Richtung auf die Öffnung 5 des Gehäuses 1 weisen. Das Gehäuse enthält ferner einen Steckverbinder 6. Das Stanzgitter 7 ist mit Kunststoff 8 umspritzt, so dass es ein stabiles Bauteil bildet, das in das Gehäuse derart eingesetzt werden kann, dass Schweißfahnen 9 des Stanzgitters 7 mit den Anschlussstiften 4 der Bauteile 3 verbunden werden können. Ein Teil 10 des Stanzgitters 7 ist flächig ausgebildet und dient zur Aufnahme einer Schaltung 11 mit einer Trägerplatte 12, verschiedenen nur angedeuteten Bauelementen und Kontaktflächen 13, 14. Auf den Teil 10 des Stanzgitters 7 wird zur Isolierung und Befestigung der Trägerplatte 12 eine klebende Isolierschicht 15 aufgebracht, die entweder eine doppelseitig klebende Folie sein kann oder eine Paste, die insbesondere im Siebdruckverfahren aufgebracht wird.

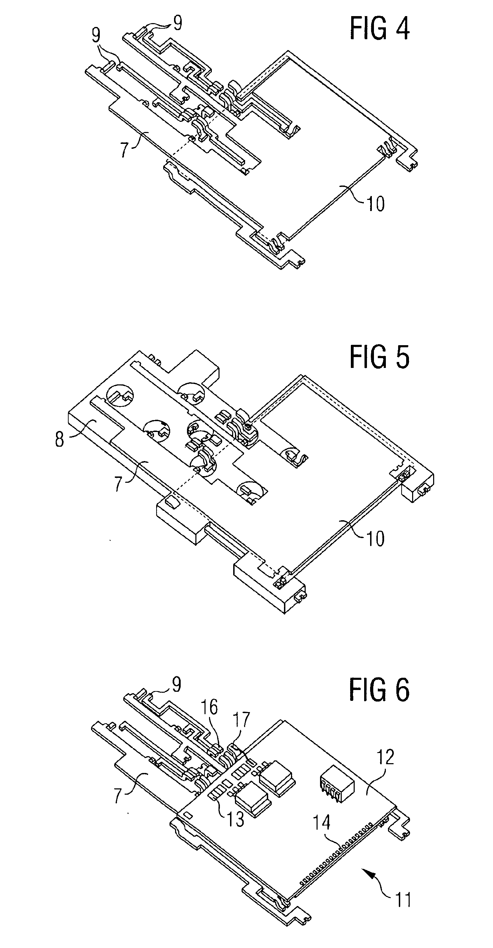

Schweißfahnen 16 des Stanzgitters 7, die zur elektrischen Verbindung mit der Schaltung 11 dienen, sind derart gekröpft, dass sie etwa in gleicher Höhe wie die Kontaktflächen 13 der Schaltung liegen, und sind mit bondfähigen Oberflächen versehen. Einer der Bonddrähte 17 ist in Fig. 6 dargestellt.

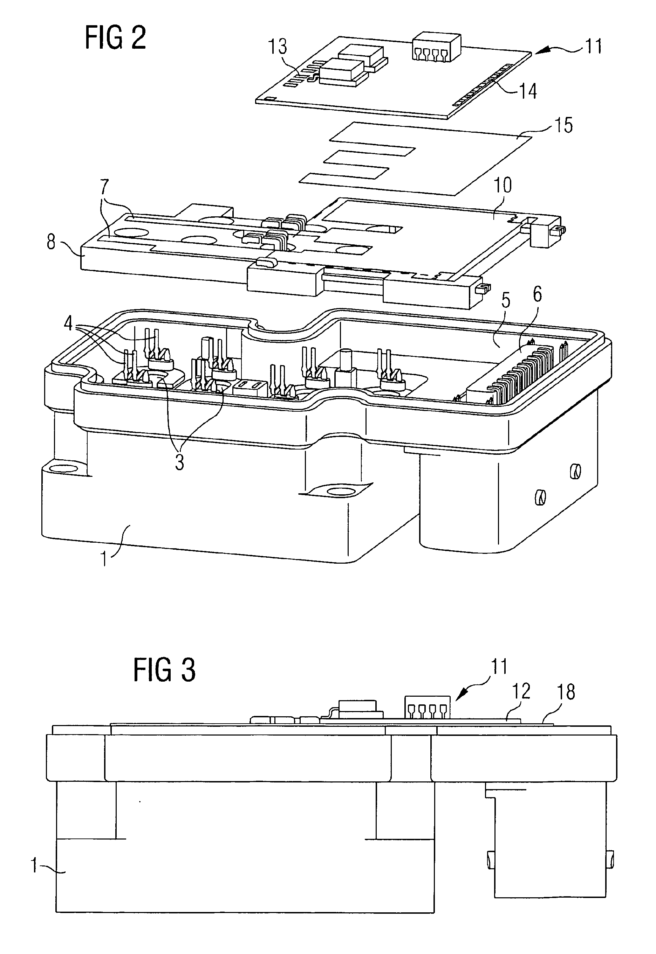

In der Seitenansicht gemäß Fig. 3 ist erkennbar, dass die als Kühlfläche für die Schaltung 11 dienende Oberfläche 18 des Stanzgitters das Gehäuse etwas überragt, so dass die Aufbringung des Klebers, beispielsweise im Siebdruckverfahren, erleichtert wird.

## Patentansprüche

1. Elektrisches Gerät mit einer auf einer Trägerplatte angeordneten Schaltung und mit einem elektrische Leitungen bildenden Stanzgitter zur elektrischen Verbindung der Schaltung mit weiteren elektrischen Bauteilen, **dadurch gekennzeichnet, dass** die Trägerplatte (12) in wärmeleitender Verbindung mit mindestens einem Teil (10) des Stanzgitters (7) steht.

2. Gerät nach Anspruch 1, **dadurch gekennzeichnet, dass** das Stanzgitter (7) mindestens teilweise flächig ausgebildet ist und dass die Trägerplatte (12) auf dem flächigen Teil (10) aufliegt.

3. Gerät nach einem der Ansprüche 1 oder 2, **dadurch gekennzeichnet, dass** eine elektrische Isolierung zwischen der Trägerplatte (12) und dem Stanzgitter (7, 10) von einer doppelseitig klebenden Folie (15) gebildet wird.

4. Gerät nach einem der Ansprüche 1 oder 2, **dadurch gekennzeichnet, dass** eine elektrische Isolierung zwischen der Trägerplatte (12) und dem Stanzgitter (7, 10) von einem aufgedruckten Kleber gebildet wird.

5. Gerät nach einem der vorhergehenden Ansprüche, **dadurch gekennzeichnet, dass** das Stanzgitter (7) mit Kunststoff (8) umspritzt ist, wobei elektrische Kontaktflächen (9, 16) und zur wärmeleitenden Verbindung mit der Trägerplatte (12) vorgesehene Flächen (18) freigelassen sind.

6. Gerät nach Anspruch 5, **dadurch gekennzeichnet, dass** das Stanzgitter (7) eine größere Fläche einnimmt als die Trägerplatte (12) und dass als Kontaktflächen (16) für die auf der Trägerplatte (12) angeordnete Schaltung (11) vorgesehene Leitungen des Stanzgitters (7) neben der Trägerplatte über die Ebene des Stanzgitters hinausragen.

7. Gerät nach einem der Ansprüche 5 oder 6, **dadurch gekennzeichnet, dass** die weiteren elektrischen Bauteile (3) in einem Gehäuse (1) angeordnet sind, wobei elektrische Kontaktelemente (4) in Richtung auf eine offene Seite (5) des Gehäuses (1) weisen und mit Kontaktflächen (9) des Stanzgitters (7) verbunden sind, dass das Kunststoff-umspritzte Stanzgitter (7, 8) die offene Seite (5) des Gehäuses (1) im Wesentlichen einnimmt, wobei die auf der Trägerplatte (12) angeordnete Schaltung (11) nach außen weist, und dass das Gehäuse (1) mit einem Deckel (2) verschließbar ist, der zur Aufnahme mindestens der Schaltung (11) ausgebildet ist.

8. Gerät nach Anspruch 7, **dadurch gekennzeichnet, dass** die zur Wärmeleitung vorgesehene Fläche (18) des Stanzgitters (7) den Rand des Gehäuses (1) überragt.
